(19) **Europäisches Patentamt**
**European Patent Office**
**Office européen des brevets**

(11) **EP 2 400 825 A1**

(12) **EUROPÄISCHE PATENTANMELDUNG**

(43) Veröffentlichungstag:
28.12.2011 Patentblatt 2011/52

(51) Int Cl.:
*H05K 3/46* (2006.01)

(21) Anmeldenummer: **10167011.5**

(22) Anmeldetag: **23.06.2010**

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**BA ME RS**

(71) Anmelder: **Bayer MaterialScience AG**
**51368 Leverkusen (DE)**

(72) Erfinder:
• **Bernert, Thomas, Dr.**
**51377 Leverkusen (DE)**
• **Mäuser, Helmut**
**51375 Leverkusen (DE)**

(54) **Isolationszusammensetzung für gedruckte Elektronik in einem Leiterkreuzungspunkt**

(57) Die vorliegende Erfindung betrifft eine Isolationszusammensetzung, umfassend mindestens ein Bindemittel und mindestens einen Abstandshalter. Beschrieben wird ferner ein Verfahren zur Herstellung einer Isolationszusammensetzung sowie Verwendung von Abstandshaltern in Isolationszusammensetzungen.

EP 2 400 825 A1

**Beschreibung**

Die vorliegende Erfindung betrifft eine Isolationszusammensetzung, insbesondere für eine gedruckte Elektronik in einem Leiterkreuzungspunkt. Des Weiteren betrifft die vorliegende Erfindung ein Verfahren zur Herstellung einer solchen Isolationszusammensetzung.

Weiterer Gegenstand der vorliegenden Erfindung ist die Verwendung einer erfindungsgemäßen Zusammensetzung zum Zweck der Isolierung von übereinander angeordneten Leiterbahnen eines gedruckten Schaltkreises. Darüber hinaus betrifft die vorliegende Erfindung die Verwendung von Abstandshaltern in Isolationszusammensetzungen, wobei die Isolationszusammensetzungen insbesondere zum Zweck der Isolation von übereinander angeordneten Leiterbahnen eines gedruckten Schaltkreises Anwendung finden.

Die vorliegende Erfindung betrifft somit das technische Gebiet der gedruckten Schaltkreise.

Werden auf einem Substrat elektrische Leiterstrukturen angeordnet, hängt der Grad an Komplexität der Leiterstrukturen maßgeblich davon ab, ob man beim Design der gedruckten Schaltung Kreuzungsmöglichkeiten unterschiedlicher Leiterbahnen vorsehen kann oder nicht. Diese Kreuzungsmöglichkeiten werden immer durch eine isolierende Schicht und einer leitenden Verbindung als Brücke über die isolierende Schicht realisiert. Anwendungen komplexer Leiterstrukturen findet man in vielen Bereichen der "Printed Electronics", aber auch im HF-Design von koplanaren Antennenstrukturen und bei der Herstellung von RFID-Antennen und Displays.

Die Herstellung von gedruckten Schaltungen ist beispielsweise aus der DE 43 32 282 A1 bekannt. In dieser Druckschrift wird ein Verfahren zum Herstellen von Leiterbahn-Mustern auf Substraten mittels Siebdruck und anschließender Wärmebehandlung zur Umwandlung der gedruckten Leiterbahnen in haftende, metallische Leiterbahnen beschrieben. Bei diesem Verfahren stellt sich gemäß der DE 43 32 282 A1 häufig das Problem einer unzureichenden Haftung auf dem Substrat. Die DE 43 32 282 A1 schlägt zur Lösung dieses Problems vor, auf die erste durch Siebdruck und anschließende Wärmebehandlung hergestellte Leiterbahn-Konfiguration mindestens auf einem Teil der Konfiguration wenigstens eine zweite Leiterbahn-Schicht mittels Siebdruck und anschließender Wärmebehandlung aufzubringen. In der DE 43 32 282 A1 wird das Problem sich kreuzender Leiterbahnen und die Frage der Isolierung zwischen diesen Leiterbahnen nicht angesprochen. Darüber hinaus weist das Verfahren gemäß DE 43 32 282 A1 den Nachteil auf, dass für das jeweilige Sintern der zwei sukzessive aufgebrachten Leiterbahnen Temperaturen oberhalb 800 °C erforderlich sind, so dass nur entsprechende Substratmaterialien eingesetzt werden können, welche diese Temperaturen insbesondere ohne Verformung überleben.

Die Druckschrift DE 298 24 033 U1 betrifft einen Träger für Halbleiter-Chips, der flächig ausgebildet ist und aus einem flexiblen, dielektrischen Material besteht, auf dem mindestens ein Halbleiter-Chip mit einer Leitbahnstruktur zur kontaktlosen Datenübertragung aufgebracht ist. Die aus einem elektrisch leitenden Polymer oder Klebstoff gebildete Leitbahnstruktur wird unmittelbar auf aus Papier, Karton, Pappe oder einem textilen Material bestehenden Träger aufgedruckt ist. Auch in dieser Druckschrift wird das Problem sich kreuzender Leiterbahnen und die Frage der Isolierung zwischen diesen Leiterbahnen nicht angesprochen.

Die Druckschrift DE 10 2007 028 357 A1 betrifft eine Transponderkarte, umfassend ein ohne Zwischenlagen zwischen zwei Schutzplatten aus Kunststoff angeordnetes Trägersubstrat, auf dem eine ebene Rahmenantenne mit zwei Speiseanschlüssen und einer die Speiseanschlüsse verbindenden Leiterbahn sowie ein integrierter Schaltkreis mit zwei Antennenanschlüssen angeordnet sind, wobei die Antennenanschlüsse mit den beiden Speiseanschlüssen elektrisch verbunden sind und der integrierte Schaltkreis relativ zur Rahmenantenne so angeordnet ist, dass die Leiterbahn nicht zwischen den Antennenanschlüssen des integrierten Schaltkreises hindurch verläuft. In einer besonderen Ausführungsform dieser Druckschrift kreuzen sich die Leiterbahnen und werden durch ein nichtleitendes Separationselement elektrisch isoliert. Das Separationselement kann durch eine zusätzliche nichtleitende Schicht gebildet werden. Diese nichtleitende Schicht ist in der DE 10 2007 028 357 A1 nicht näher beschrieben.

Die Druckschrift EP 1 535 957 A betrifft eine Thermoisolierplatte zur Außenisolierung von Werkzeugen auf Basis von Füllstoffe enthaltenden thermostabilen Kunststoffen. Bei dem thermostabilen Kunststoff handelt es sich um Polytetrafluorethylen (PTFE) und bei den Füllstoffen handelt es sich um Hohlkugeln mit einem mittleren Durchmesser von 0,01 bis 300 μm. Der Anteil an Hohlglaskugeln in der Thermoisolierplatte beträgt 5 bis 70 Gew.-%. Die Hohlkugeln können aus chemisch beständigem Glas, aus Keramik oder aus hochtemperaturbeständigen thermoplastischen Kunststoffen bestehen. Die Verwendung von Zusammensetzungen zur Isolierung von Leiterbahnen wird in der Druckschrift nicht angesprochen.

Kommerziell werden viele Pastensysteme angeboten, die sich prinzipiell zur Herstellung von Isolationsbrücken eignen. Die Trocknung dieser Pasten erfolgt jedoch meist bei hohen Temperaturen, beispielsweise über 80 °C oder sogar über 100 °C, was die Auswahl der Materialien für Substrate einschränkt. So können nur Substratmaterialien verwendet werden, die bei den genannten Temperaturen verzugsfrei bleiben, beispielsweise Polycarbonat (PC) oder Polyethylenterephthalat (PET). Die Isolationsbrücke muss zudem zwischen den Leiterbahnen eine gewisse Höhe bzw. Dicke haben um ausreichend isolierend zu wirken. Da viele kommerziell erhältliche Siebdruckpasten jedoch nur geringe Schichtdicken ermöglichen, muss die Isolationsbrücke durch mehrfaches Drucken aufgetragen werden, womit auch die Belastung der Folie durch Energieeintrag beim Trocknen reduziert werden soll. Dieses erfordert jedoch mehrfache Trocknungsschritte, was zusätzlich Energie und Zeit verbraucht und den Prozess unwirtschaftlich macht. Alternativ kann die Isolationsbrücke auch durch eine isolierende Schutzfolie mit Freistellungen im Kontaktbereich gebildet werden und darüber der zweite Leiter gedruckt werden. Dies erfordert jedoch ein genaues Ausrichten der Schutzfolie. Problematisch sind hier die Temperaturempfindlichkeit des Laminats und daraus resultierend die mangelnde Formstabilität.

Verfahrenstechnisch und ökonomisch vorteilhaft wäre es darüber hinaus, billigere Substrate als diejenigen aus Polycarbonat verwenden zu können. Ein diesbezüglich interessantes Substratmaterial ist beispielsweise Polyvinylchlorid (PVC). Dieses Material weist jedoch eine niedrige Glasübergangstemperatur $T_g$ von 80 °C auf, so dass übliche Temperaturen, bei welchen die Trocknung von Isolationszusammensetzungen erfolgt, nicht angewendet werden können und es bei üblichen Trocknungstemperaturen zu einer Verformung des Substrats kommt. So kann es bereits bei Temperaturen von über 60 °C zu einer Verformung eines Polyvinylchloridsubstrates kommen.

Gleichzeitig eignen sich kommerziell erhältliche Pasten zur Herstellung von Isolationsbrücken in der Regel nicht für eine thermische Trocknung bei niedrigen Temperaturen, bei denen Substrate, wie Substrate aus Polyvinylchlorid, verzugsfrei bleiben. Auch die Verwendung von UVtrocknenden Lacken führt zu einem Energieeintrag, der zum Verzug beispielsweise einer Folie aus Polyvinylchlorid führen kann.

Eine erste Aufgabe, die sich die vorliegende Erfindung daher stellt, ist die Bereitstellung einer Isolationszusammensetzung, die nach dem Auftrag auf ein mit einer Leiterbahn versehenem Substrat bei niedrigen Temperaturen, insbesondere bei Temperaturen von unterhalb 70 °C, getrocknet werden kann.

Eine weitere Aufgabe, welche sich die vorliegende Erfindung stellt, ist die Bereitstellung einer Isolationszusammensetzung, welche bei Schichtdicken, die erforderlich sind, um eine ausreichende Isolationswirkung zu erzielen, bei niedrigen Temperaturen, insbesondere bei Temperaturen von unterhalb 70 °C, getrocknet werden kann. Entsprechende Schichtdicken, die erforderlich sind, um eine ausreichende Isolation zu bewirken, liegen üblicherweise in einem Bereich von 3 bis 40 μm.

Eine weitere Aufgabe der vorliegenden Erfindung ist die Bereitstellung einer Isolationszusammensetzung, welche in einem vorzugsweise einfachen Druckprozess mit weiter bevorzugt einem einzigen Nass-Druckschritt oder einem einzigen Nass-in-Nass-Druckschritt in einer die Isolation bewirkenden ausreichenden Dicke aufgetragen werden kann, so dass die Belastung des Substrats durch Energieeintrag beim Trocknen nach dem Auftragen der Isolationszusammensetzung reduziert wird.

Gelöst werden diese Aufgaben durch die im Folgenden näher beschriebene erfindungsgemäße Isolationszusammensetzung. Die erfindungsgemäße Isolationszusammensetzung ist dadurch gekennzeichnet, dass sie mindestens einen isolierenden Abstandshalter mit einer mittleren Teilchengröße $d_{50}$ von 3 bis 40 μm umfasst.

Im Rahmen der vorliegenden Erfindung wird unter einem Abstandhalter ein Bestandteil der Isolationszusammensetzung verstanden, der einerseits isolierende Eigenschaften aufweist und andererseits aufgrund Teilchengröße und Teilchenform eine kompakt gefüllte und daher zuverlässig dicke Isolationsschicht ergibt. In einer bevorzugten Ausgestaltung weisen die Abstandshalter eine im Wesentlichen kugelförmige Form auf und ergeben - als Isolationszusammensetzung aufgetragen - eine im Wesentlichen dichteste Kugelpackung.

Als Abstandshalter kommen daher Bestandteile in Betracht, die einerseits ausreichende isolierende Eigenschaften und andererseits eine ausreichende Teilchengröße und Teilchenform aufweisen.

Durch die isolierenden Eigenschaften der Abstandshalter wird sichergestellt, dass in Schaltkreisen im Bereich der Kreuzungspunkte von Leiterbahnen es zu keinen unzulässigen kapazitiven Belastungen kommt. Durch die Teilchengröße des Abstandshalters wird ferner eine ausreichende Höhe des Isolationsmaterials sichergestellt.

In einer bevorzugten Ausgestaltung der vorliegenden Erfindung können Abstandshalter verwendet werden, die lichtkonvertierende Eigenschaften aufweisen, was die visuelle Kontrolle der Einbettung der Abstandshalter in die Isolationszusammensetzung ermöglicht. Ferner können die Abstandshalter IR-absorbierende Eigenschaften aufweisen, so dass der Wärmeeintrag vorzugsweise in die Isolationsschicht und nicht in das Substrat erfolgt.

In erster Näherung wird die kapazitive Last durch zwei Parameter beeinflusst, nämlich die Permittivität und den Abstand zwischen den Leiterbahnen. Als vorteilhaft hat sich im Rahmen der vorliegenden Erfindung die Verwendung von Abstandshaltern herausgestellt, die mittlere Teilchendurchmesser $d_{50}$ von 3 bis 40 μm aufweisen. Darüber hinaus ist es des Weiteren bevorzugt, wenn die Abstandshalter einen mittleren Teilchendurchmesser $d_{90}$ von 0,5 bis 20 μm aufweisen (im Folgenden in Mischung mit anderen Abstandshaltern auch als "erste Abstandshalter" bezeichnet).

Des Weiteren ist es im Rahmen der vorliegenden Erfindung bevorzugt, wenn die im Wesentlichen kugelförmigen Abstandshalter eine enge Größenverteilung aufweisen. Eine enge Größenverteilung im Sinn der vorliegenden Erfindung ist beispielsweise dann gegeben, wenn

(1) der Anteil an Teilchen, der ein Sieb der Größe 12 μm passiert, bei 75 bis 97 %;

(2) der Anteil an Teilchen, der ein Sieb der Größe

22 μm passiert, bei 99 bis 100 %; und

(3) der Anteil an Teilchen, der ein Sieb der Größe 45 μm passiert, bei 100 %

liegt.

In einer weiteren Ausführungsform der Erfindung enthält die Formulierung Füllstoffe unterschiedlicher Teilchengrößen. Dadurch kann man eine dichtere Packung der Füllstoffteilchen in der Bindemittelmatrix erreichen.

So können Abstandshalter verschieden spezifizierter Teilchengrößen gemischt werden, um die Teilchenpackung in der Druckschicht zu verdichten. So können beispielsweise zu Teilchen der oben beschriebenen Größe ("erste Abstandshalter") Abstandshalter mit einem mittleren Durchmesser $d_{50}$ von 12 bis 26 μm zugegeben werden. Diese Teilchen weisen ferner vorzugsweise einen mittleren Teilchendurchmesser $d_{90}$ von 0,5 bis 70 μm auf. Im Folgenden werden diese Abstandshalter in Mischung mit anderen Abstandshaltern auch als "zweite Abstandshalter" bezeichnet.

Das Mischungsverhältnis dieser beiden unterschiedlichen Teilchen kann in einem weiten Bereich liegen, beispielsweise 100 : 0 erste zu zweite Abstandshalter bis 0 : 100 erste zu zweite Abstandshalter.

Des Weiteren ist es bevorzugt, wenn die Abstandshalter eine vorgegebene Größe nicht überschreiten, da zu große Abstandshalter sich im Allgemeinen nicht dicht genug packen lassen, so dass die Schichtdicke zwischen den Abstandshaltern zu stark einsackt. In diesem Fall würde man zwar eine für die Isolation prinzipiell ausreichende Dicke der Schicht messen, im Mikroskop sieht man aber, dass der Abstand der Kugeln zueinander sehr groß ist und zwischen den Kugeln nur noch wenige μm Schichtdicke sind. Daher weisen die erfindungsgemäß zu verwendenden Abstandshalter vorzugsweise einen mittleren Teilchendurchmesser $d_{50}$ von weniger als 40 μm, besonders bevorzugt von weniger als 35 μm, insbesondere weniger als 30 μm, auf.

Die erfindungsgemäße Isolationszusammensetzung ist in einer weiteren Ausführungsform des Weiteren vorzugsweise dadurch gekennzeichnet, dass der Abstandshalter in einer wesentlichen kugelförmigen Form vorliegt. Hierdurch wird eine im Wesentlichen dichteste Packung der Abstandshalter in der Isolationszusammensetzung realisiert, was im Allgemeinen zu einer gleichförmigen Höhe der Isolationsschicht führt. Ohne an eine Theorie gebunden sein zu wollen scheint die Kugelform im Vergleich zu unförmigen Füllstoffen beim Druckprozess darüber hinaus ein Abrollen zu bewirken, wodurch die Standzeit des bei dem Siebdruckverfahren verwendeten Siebes entsprechend hoch ist. Daher liegt der Abstandshalter im Wesentlichen in einer kugelförmigen Struktur vor.

Im Rahmen der vorliegenden Erfindung wird unter dem Begriff einer kugelförmigen Struktur verstanden, dass der Abstandshalter die Beziehung

$$L1 = 1 \text{ bis } 1,5 \text{ x } L2,$$

bevorzugt

$$L1 = 1 \text{ bis } 1,3 \text{ x } L2,$$

besonders bevorzugt

$$L1 = 1 \text{ bis } 1,1 \text{ x } L2,$$

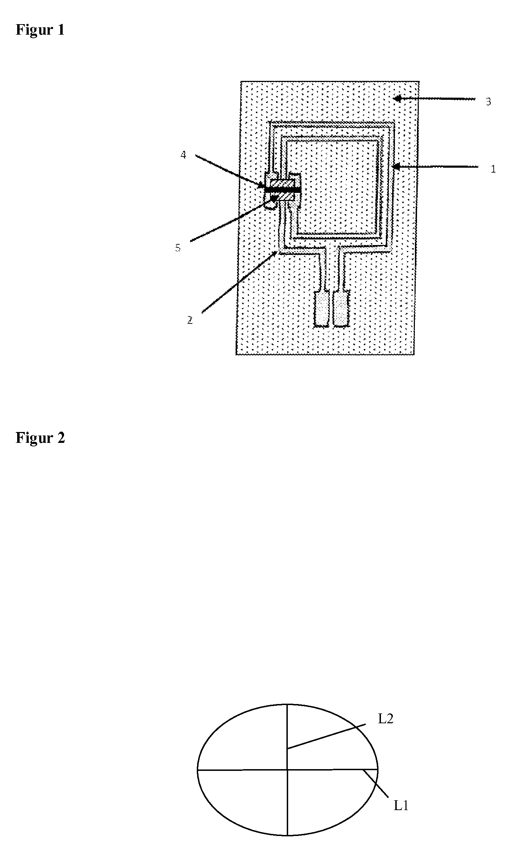

erfüllt, wenn L1 der größte Durchmesser und L2 der kleinste Durchmesser der zweidimensionalen Darstellung eines entsprechenden Formkörpers darstellt. Eine entsprechende Darstellung eines erfindungsgemäßen Formkörpers einschließlich der Darstellung von zwei entsprechenden Durchmessern L1 und L2 ist in der Figur 2 dargestellt.

Der erfindungsgemäß vorgesehene Abstandshalter kann Glas, mindestens einen keramischen Werkstoff und/oder mindestens ein Polymer umfassen und in besonderen Ausgestaltungen der vorliegenden Erfindung auch aus Glas, einem keramischen Werkstoff und/oder einem Polymer bestehen. In weiteren Ausgestaltung kann der Abstandshalter auch Mineralglas umfassen. In dieser Ausgestaltung ist insbesondere die Verwendung von Kieselglas und/oder Quarzglas zu erwähnen.

Wenn die erfindungsgemäße Isolationszusammensetzung einen Abstandshalter enthält, der mindestens einen keramischen Werkstoff umfasst, so kann der keramische Werkstoff beispielsweise ausgewählt werden aus der Gruppe, bestehend aus Titandioxid, Calciumcarbonat, Zirkoniumdioxid, Aluminiumoxid, Magnesiumoxid, Zinkoxid und Mischungen davon.

Wenn die erfindungsgemäße Isolationszusammensetzung einen Abstandshalter enthält, der mindestens ein Polymer umfasst, so kann das Polymer beispielsweise ausgewählt werden aus der Gruppe, bestehend aus Divinylbenzol und Mischungen aus Divinylbenzol und Polystyrol.

Im Rahmen der vorliegenden Erfindung ist es insbesondere bevorzugt, wenn der Abstandshalter Glas umfasst und insbesondere aus Glashohlkugeln aufgebaut ist.

Ein weiteres wichtiges Eigenschaftsmerkmal geeigneter Abstandshalter ist ferner insbesondere, dass die Isolationszusammensetzung mit Hilfe der folgenden beschriebenen Beschichtungsverfahren auf entsprechende Substrate bzw. Leiterstrukturen aufgebracht werden kann:

Im Rahmen der vorliegenden Erfindung eignen sich als Druck- und/oder Beschichtungsverfahren zum Auftrag der erfindungsgemäßen Isolationszusammensetzung und damit beispielsweise zur Herstellung von Isolationsbrücken prinzipiell alle dem Fachmann bekannten Coating- und Druckverfahren, beispielsweise Rakeln, Lackschleudern (Spincoating), Tauchlackieren (Dipcoating), Sprühlackieren (Spraycoating), Vorhanggießen (Curtaincoating), Beschichtung mittels Düsenauftrag (Slot-dye-coating), Hochdruck (z.B. Flexodruck), Flachdruck (z.B. Offsetdruck), Durchdruck (z.B. Siebdruck), Tiefdruck (z.B. Gravurdruck), Tampondruck und / oder Thermotransferdruck.

Insbesondere kann die Isolationsbrücke durch Rakeln, Lackschleudern (Spincoating), Tauchlackieren (Dipcoating), Sprühlackieren (Spraycoating) und/oder Vorhanggießen (Curtaincoating) in Kombination mit Matrizen, Masken oder Schablonen aufgebracht werden, wobei die Schablone das Substrat (beispielsweise eine PVC-Folie) insbesondere an den Stellen, die nicht beschichtet werden sollen, verdeckt.

Als Beschichtungsverfahren ohne Matrizen, Masken oder Schablonen können insbesondere Beschichtung mittels Düsenauftrag (Slot-dye-coating), Hochdruck (z.B. Flexodruck), Flachdruck (z.B. Offsetdruck), Durchdruck (z.B. Siebdruck), Tiefdruck (z.B. Gravurdruck), Tampondruck und / oder Thermotransferdruck verwendet werden.

In einer besonderen Ausgestaltung der vorliegenden Erfindung erfolgt der Auftrag der erfindungsgemäßen Isolationszusammensetzung insbesondere durch Siebdruck.

Erfindungsgemäß hat sich herausgestellt, dass die beanspruchte Isolationszusammensetzung bei verhältnismäßig niedrigen Temperaturen getrocknet werden kann, so dass in Kombination mit der Isolationszusammensetzung auch Substrate (beispielsweise für Schaltkreise) verwendet werden können, die eine niedrige Erweichungstemperatur aufweisen.

Die beanspruchte Isolationszusammensetzung kann bei Temperaturen von unterhalb 70 °C, besonders bevorzugt von unterhalb 65 °C, insbesondere von unterhalb 60 °C, getrocknet werden, wobei unter dem Begriff einer *trockenen* Isolationszusammensetzung im Allgemeinen Isolationszusammensetzungen verstanden werden, bei welchen nach der Trocknung der Isolationsbrückenschicht bei den angegebenen Temperaturen ein Gitterschnitttest zur Prüfung der Vollständigkeit der Trocknung durchgeführt werden kann. Wird der Gitterschnitttest mit einem Gitterschnittkennwert (GT-Wert) "0" bewertet, ist die Schicht im Sinne der Erfindung trocken. Dabei bedeutet ein GT-Wert von "0", dass nach dem Schneiden mit dem Gitterschnittgerät (sechs parallele Schnitte im Abstand von 1 mm und senkrecht dazu ebenfalls sechs parallele Schnitte im Abstand von 1 mm) keine Ablösung der Druckschicht nach Abziehen des Klebebands festgestellt werden kann.

Dabei hat sich erfindungsgemäß herausgestellt, dass durch die Auswahl geeigneter Bindemittel und geeigneter Lösemittel in Kombination mit den erfindungsgemäß vorgesehenen Abstandshaltern es möglich ist, die Isolationszusammensetzung mit einem einzigen Siebdruckschritt entweder im Nassverfahren oder im Nass-in-Nass-Verfahren zu drucken. Die Auswahl geeigneter Bindemittel bzw. Lösemittel wird weiter unten noch näher erläutert.

Im Folgenden werden weitere Bestandteile der erfindungsgemäßen Isolationszusammensetzung beschrieben:

Die erfindungsgemäße Isolationszusammensetzung kann ein Bindemittel enthalten. Dieses ist bevorzugt ausgewählt aus der Gruppe bestehend aus Celluloseestern, Cellusoseethern, Kautschukderivaten, Polyesterharzen, ungesättigten Polyestern, Alkydharzen, Phenolharzen, Aminoharzen, Amidoharzen, Ketonharzen, Xylol-Formaldehydharzen, Epoxidharze, Phenoxyharzen, Polyolefinen, Polyvinylchlorid, Polyvinylestem, Polyvinylalkoholen, Polyvinylacetalen, Polyvinylethern, Polyacrylaten, Polymetacrylaten, Polystyrolen, Polycarbonaten, Polyestern, Copolyestern, Polyamiden, Silikonharzen, Polyurethanen und Mischungen davon.

Bevorzugt ist es, wenn das Bindemittel Polyurethan umfasst. Dabei kann das Bindemittel im Einzelnen ausgewählt werden aus der Gruppe, bestehend aus Einkomponenten-Polyurethanen, Zweikomponenten-Polyurethanen, wässrigen Polyurethandispersionen und Polyurethan-Schmelzklebstoffen.

Bevorzugt kann die Paste ein oder mehrere Einkomponenten-Polyurethane umfassen oder daraus ausgebildet sein, welche Prepolymere, herstellbar durch Reaktion von Alkoholen mit einem stöchiometrischen Überschuss von polyfunktionellen Isocyanaten mit einer mittleren Funktionalität größer als 2 und bis zu 4, umfassen. Diese Prepolymere können gegebenenfalls weiterhin Zusatzstoffe und/oder Lösungsmittel umfassen. Die Prepolymere können beispielsweise durch Umsetzung von Polyisocyanaten mit Alkoholen, die Mischungen von Polyolen mit im Mittel monofunktionellen Alkoholen darstellen, unter Ausbildung von Urethangruppen und endständigen Isocyanatgruppen erhalten werden.

Besonders bevorzugt enthält die Paste als Bindemittel ein Polycarbonat oder eine Mischung aus verschiedenen Polycarbonaten oder Kunststoffblends aus Polycarbonat und anderen Kunststoffen wie beispielsweise ABS.

Die erfindungsgemäße Zusammensetzung enthält darüber hinaus im Allgemeinen mindestens ein Lösemittel. Das Lösemittel wird vorzugsweise so ausgewählt, dass das Bindemittel aufgelöst wird und gleichzeitig keine Schädigung des Substrats auftritt. Darüber hinaus sollte das Bindemittel aber eine vollständige Benetzung des Substrats mit der erfindungsgemäßen Isolationszusammensetzung ermöglichen. Geeignete Lösemittel sind beispielsweise 2-Methoxy-1-methylethylacetat, 1,2,4-Trimethylbenzol, Ethyl-3-ethoxypropionat und Naphtha sowie beliebige Mischungen der zuvor erwähnten Lösemittel.

Die Auswahl an geeigneten Bindemitteln und Lösemitteln hängt einerseits davon ab, dass die resultierende erfindungsgemäße Isolationszusammensetzung bei niedrigen Temperaturen von beispielsweise unterhalb 70 °C getrocknet werden kann. Andererseits müssen Lösemittel und Bindemittel so aufeinander abgestimmt werden, dass bei der Applikation der erfindungsgemäßen Isolationszusammensetzung durch Siebdruck es nicht zu einer Verstopfung des Siebs kommt.

Mit Hilfe des Siebdruck-Verfahrens lassen sich in einem einzigen Verfahrensschritt entweder im Nassverfahren oder im Nass-in-Nass-Verfahren Schichtdicken der Isolationsschicht von 10 bis 70 μm, besonders bevorzugt 20 bis 50 μm, erreichen.

Die erfindungsgemäße Isolationszusammensetzung kann mindestens einen weiteren Bestandteil, ausgewählt aus der Gruppe, bestehend aus Additiven, (weiteren) Füllstoffen und Mischungen davon, umfassen.

Im Rahmen der vorliegenden Erfindung kann das Additiv beispielsweise ausgewählt werden aus der Gruppe, bestehend aus Verdickern, Rheologieadditiven, Haftvermittlern, Entschäumern, Entlüftern, Verlaufsmitteln und Mischungen davon.

Die einzelnen Bestandteile der erfindungsgemäßen Isolationszusammensetzung können in weiten Mengenbereichen in der Zusammensetzung enthalten sein, so lange sie ihre funktionelle Aufgabe in der Zusammensetzung ausreichend ausführen können. Entsprechende Gehälter der einzelnen Bestandteile können von dem Fachmann durch Routineversuche ermittelt werden.

Im Allgemeinen beträgt der Anteil an Abstandshalter, jeweils bezogen auf die Isolationszusammensetzung, 1 bis 90 Gew.-%, vorzugsweise 10 bis 80 Gew.-%, besonders bevorzugt 20 bis 70 Gew.-%.

Im Allgemeinen beträgt der Anteil an Bindemittel, jeweils bezogen auf die Isolationszusammensetzung, 1 bis 70 Gew.-%, vorzugsweise 5 bis 60 Gew.-%, besonders bevorzugt 10 bis 50 Gew.-%.

Die erfindungsgemäße Zusammensetzung kann vorzugsweise bei niedrigen Temperaturen getrocknet werden. Insbesondere ist es im Rahmen der vorliegenden Erfindung möglich, die erfindungsgemäße Isolationszusammensetzung bei einer Temperatur niedriger als 70 °C, besonders bevorzugt niedriger als 65 °C, besonders bevorzugt niedriger als 60 °C, effizient zu trocknen. Damit ist es im Rahmen der vorliegenden Erfindung auch möglich, Schaltkreise auf Substraten zu erzeugen, welche bei höheren Temperaturen, insbesondere bei Temperaturen höher als 70 °C, besonders bevorzugt höher als 65 °C, besonders bevorzugt höher als 60 °C, eine Deformation erleiden und daher in Kombination mit herkömmlichen Isolationszusammensetzungen des Standes der Technik nicht verwendet werden können.

Ein bevorzugtes Substrat, welches in Kombination mit der erfindungsgemäßen Isolationszusammensetzung verwendet werden kann, ist Polyvinylchlorid (PVC). Da dieses Material bereits bei niedrigen Temperaturen oberhalb von 60 °C bei länger anhaltender Temperaturbelastung und Temperaturen oberhalb von 70 °C bei kurzzeitiger Temperatureinwirkung weich wird, müssen auch die auf diesem Substrat vorgesehenen Druckschichten bei diesen moderaten Temperaturen getrocknet werden. Die erfindungsgemäße Zusammensetzung zur Herstellung der Isolationsbrücke enthält dementsprechend Lösungs- und Bindemittel, die eine Trocknung bei Temperaturen von unterhalb 70 °C ermöglichen. Geeignete Lösemittel hierfür sind beispielsweise die bereits erwähnten 2-Methoxy-1-methylethylacetat, 1,2,4-Trimethylbenzol, Ethyl-3-ethoxypropionat, Naphtha und beliebige Mischungen davon. Diese Lösemittel werden insbesondere in Kombination mit einem Polycarbonat-Bindemittel verwendet.

Weiterer Gegenstand der vorliegenden Erfindung ist ein elektrischen Schaltkreis, umfassend ein Substrat und darauf vorgesehen mindestens eine Leiterbahn, wobei die Leiterbahn durch eine getrocknete erfindungsgemäße Isolationszusammensetzung abgedeckt wird. Das Substrat kann vorzugsweise ein Substrat sein, welches bei Temperaturen von höher als 70 °C, besonders bevorzugt höher als 65 °C, besonders bevorzugt höher als 60 °C, eine Deformation erleidet. Alternative können auch beliebige andere Substrate im Rahmen der vorliegenden Erfindung, beispielsweise Substrate auf Polycarbonatbasis, verwendet werden.

Die Herstellung dieses erfindungsgemäßen Schaltkreises erfolgt nach dem Fachmann an sich bekannten Verfahren. Die einzelnen Leisterbahnen sowie die Isolationsbrücke des Schaltkreises können mit dem Fachmann bekannten Coating- und Druckverfahren, beispielsweise Rakeln, Lackschleudern (Spincoating), Tauchlackieren (Dipcoating), Sprühlackieren (Spraycoating), Vorhanggießen (Curtaincoating), Beschichtung mittels Düsenauftrag (Slot-dye-coating), Hochdruck (z.B. Flexodruck), Flachdruck (z.B. Offsetdruck), Durchdruck (z.B. Siebdruck), Tiefdruck (z.B. Gravurdruck), Tampondruck und / oder Thermotransferdruck, auf dem Substrat aufgebracht werden.

Insbesondere kann die Isolationsbrücke durch Rakeln, Lackschleudern (Spincoating), Tauchlackieren (Dipcoating), Sprühlackieren (Spraycoating) und/oder Vorhanggießen (Curtaincoating) in Kombination mit Matrizen, Masken oder Schablonen aufgebracht werden, wobei die Schablone das Substrat (beispielsweise eine PVC-Folie) insbesondere an den Stellen, die nicht beschichtet werden sollen, verdeckt.

Als Beschichtungsverfahren ohne Matrizen, Masken oder Schablonen können insbesondere Beschichtung mittels Düsenauftrag (Slot-dye-coating), Hochdruck (z.B. Flexodruck), Flachdruck (z.B. Offsetdruck), Durchdruck (z.B. Siebdruck), Tiefdruck (z.B. Gravurdruck), Tampondruck, Digitaldruck und / oder Thermotransferdruck verwendet werden.

Bevorzugt ist das Aufbringen der Isolationsbrücke im Siebdruckverfahren, wie bereits zuvor erläutert.

Die erfindungsgemäße Isolationszusammensetzung kann demgemäß insbesondere in der Form einer isolierenden Schicht, beispielsweise auf einem elektrischen Schaltkreis zwischen zwei Leiterbahnen, vorliegen.

Ein weiterer Gegenstand der vorliegenden Erfindung ist ferner ein Verfahren zur Herstellung entsprechender erfindungsgemäßer Isolationszusammensetzungen. Zu diesem Zweck werden die einzelnen zuvor beschriebenen Bestandteile in beliebiger Reihenfolge miteinander gemischt. Auch ist es möglich, die erfindungsgemäß vorgesehenen Abstandshalter kommerziell erhältlichen Isolationszusammensetzungen zuzumischen. Als kommerzielle Isolationszusammensetzungen können eine Vielzahl von kommerziell erhältlichen Produkten, insbesondere als Bindemittel, geeignet sein, welche beispielsweise unter den Handelsnamen Noriphan HTR, Noriphan PCI, Noriphan N2K, Noricryl und NoriPET von der Firma Pröll KG, Weißenburg in Bayern, Deutschland, oder unter dem Handelsnamen Maraflex FX von der Firma Marabu GmbH & Co. KG, Tamm, Deutschland, oder unter dem Handeisnamen Polyplast PY von der Firma Fujifilm Sericol Deutschland GmbH oder unter den Handelsnamen Siebdruckfarben HG, SG, CP, CX, PK, J, TL sowie YN von der Firma Coates Screen Inks GmbH oder unter den Handeisnamen 1500 Series UV Plexiform, 1600 Power Print Series, 1700 Versa Print, 3200 Series, 1800 Power Print plus, 9700 Series, PP Series, 7200 Lacquer und 7900 Series von der Firma Nazdar, Shawnee, Vereinigte Staaten von Amerika, vertrieben werden.

Die vorliegende Erfindung betrifft daher in einer weiteren Ausführungsform auch die Verwendung von Abstandshaltern der zuvor beschriebenen Art in Isolationszusammensetzungen.

Die erfindungsgemäße Isolationszusammensetzung kann in allen Bereichen der "Printed Electronics", aber auch im HF-Design von koplanaren Antennenstrukturen und bei der Herstellung von RFID-Antennen und Displays zu Isolationszwecken verwendet werden.

Im Folgenden wird unter Bezugnahme auf die Figur 1 ein Beispiel einer Anwendung der erfindungsgemäßen Isolationszusammensetzung näher beschrieben:

Figur 1 zeigt eine als RFID-Antenne ausgebildete gedruckte Elektronik mit einem Leiterkreuzungspunkt. Für diesen Zweck werden zwei Leiterbahnen 1 und 2 koplanar auf einem PVC-Substrat 3 durch Siebdruck erzeugt. Die zwei Leiterbahnen 1 und 2 werden an ihrem jeweiligen Ende über einen Verbindungsleiter 4 miteinander verbunden, um eine Induktivität bereitzustellen. Um einen Kurzschluss in der resultierenden Leiterschleife zu verhindern, ist ein isolierender Überdruck (Isolationsbrücke) 5 der Leiterbahnen 1 und 2 unterhalb des Verbindungsleiters 4 erforderlich. Dieser isolierende Überdruck (Isolationsbrücke) wird durch erfindungsgemäße Isolationszusammensetzung gebildet. Die vorliegende Erfindung wird anhand der nachfolgenden Beispiele näher beschrieben, ohne darauf beschränkt zu sein.

Beispiel 1

Zur Formulierung einer erfindungsgemäßen Druckpaste wurde 70,2 g von einem Gemisch aus Pröll Noriphan HTR 093 Klarlack (80 Gew.-%) und Noriphan HTR 097 Verzögerer (20 Gew.-%) in einem Polypropylen-Kunststoffbecher vorgelegt und mit 14,4 g $TiO_2$ (Kronos Titan GmbH) versetzt. Anschließend wurden 15,4 g Glashohlkugeln S60 (3M® Deutschland GmbH, 41453 Neuss) zugesetzt. Diese Glashohlkugeln weisen einen $d_{50}$-Wert von 30 $\mu m$ auf. Der Becher wurde verschraubt und in einem Biaxialmischer B1AX 22/23 der Firma Collomix Rühr- und Mischgeräte GmbH für drei Minuten homogenisiert. Diese Mischung wurde anschließend über Leiterbahnen aus Silber auf einer PVC Folie im Siebdruckverfahren gedruckt. Die Trocknung erfolgte im Durchlauftrockner bei 65 °C und anschließend 30 Minuten im Umlufttrockenschrank bei 58 °C. In einem anschließenden Druckschritt wurde eine weitere Silberleiterbahn über die Isolationsbrücke gedruckt.

Nach der Trocknung wurden die Schichtdicken gemessen. Die Dicke der Silberleiterbahnen betrug 28 bis 32 $\mu m$ und die Dicke der Isolationsbrücke und der Silberleiterbahnen zusammen betrug 60 bis 67 $\mu m$. Die Dicke der reinen Isolationsbrücke betrug somit etwa 30 bis 35 $\mu m$. Die Messung der Dicken erfolgte mit einem digitalen Messtaster GT-H10 von Keyence (Keyence Deutschland GmbH, 63263 Neu-Isenburg).

Beispiel 2

Zur Formulierung einer weiteren erfindungsgemäßen Druckpaste wurden 49,2 g von einem Gemisch aus Pröll Noriphan HTR 093 Klarlack (80 Gew.-%) und Noriphan HTR 097 Verzögerer (20 Gew.-%) in einem Polypropylen-Kunststoffbecher vorgelegt und mit 49,2 g Spheriglass microspheres 5000 (Velox GmbH, 20457 Hamburg) versetzt. Anschließend wurden 1,6,g Tagesleuchtpigment (Astral Pink von Swada, Stalybridge, England) zugesetzt. Die Glaskugeln weisen mittlere Durchmesser von 3,5 bis 7,0 $\mu m$ auf. Der Becher wurde verschraubt und in einem Thinkymixer ARE-250 für zwei Minuten homogenisiert. Diese Mischung wurde anschließend über Leiterbahnen aus Silber auf einer PVC Folie im Siebdruckverfahren gedruckt. Die Trocknung erfolgte im Trockenschrank bei 55 °C für 30 Minuten. In einem anschließenden Druckschritt wurde eine weitere Silberleiterbahn über die Isolationsbrücke gedruckt.

Wie in Beispiel 1 wurden nach der Trocknung die Schichtdicken gemessen. Die Dicke der Isolationsbrücke betrug 30 bis 35 $\mu$m. Zur Bestimmung der Haftfestigkeit und damit der vollständigen Trocknung wurde ein Gitterschnitttest durchgeführt. Bei einer Temperatur von 23 °C und einer relativen Luftfeuchtigkeit von 30 % wurde mit einem Klebeband Tesa 4104 ein Gitterschnittkennwert von "0" ermittelt.

Beispiel 3

Zur Formulierung einer weiteren erfindungsgemäßen Druckpaste wurden 37,16 g von einem Gemisch aus Pröll Noriphan HTR 093 Klarlack (80 Gew.-%) und Noriphan HTR 097 Verzögerer (20 Gew.-%) in einem Polypropylen-Kunststoffbecher vorgelegt und mit 41,37 g Spheriglass microspheres 5000 sowie 20,56 g Spheriglass microspheres 3000 (Velox) versetzt. Anschließend wurden 0,92 g Tagesleuchtpigment (Astral pink von Swada) zugesetzt. Die Glaskugeln weisen mittlere Durchmesser von 3,5 bis 7,0 $\mu$m (Spheriglass 5000) bzw. 12 bis 26 $\mu$m (Spheriglass 3000) auf. Der Becher wurde verschraubt und in einem Thinkymixer ARE-250 für zwei Minuten homogenisiert. Diese Mischung wurde anschließend über Leiterbahnen aus Silber auf einer PVC Folie mittels Siebdruck gedruckt. Die Trocknung erfolgte im Trockenschrank bei 55 °C für 30 Minuten. In einem anschließenden Druckschritt wurde eine weitere Silberleiterbahn über die Isolationsbrücke gedruckt.

Wie in Beispiel 1 wurden nach der Trocknung die Schichtdicken gemessen. Die Dicke der Isolationsbrücke betrug 65 bis 75 $\mu$m.

**Patentansprüche**

1. Isolationszusammensetzung, **dadurch gekennzeichnet, dass** sie mindestens einen isolierenden Abstandshalter mit einer mittleren Teilchengröße $d_{50}$ von mindestens 3 bis 40 $\mu$m umfasst.

2. Isolationszusammensetzung nach Anspruch 1, **dadurch gekennzeichnet, dass** der Abstandshalter in einer wesentlichen kugelförmigen Form vorliegt.

3. Isolationszusammensetzung nach Anspruch 1 oder 2, **dadurch gekennzeichnet, dass** der Abstandshalter Glas, mindestens einen keramischen Werkstoff und/oder mindestens ein Polymer umfasst.

4. Isolationszusammensetzung nach einem der Ansprüche 1 bis 3, **dadurch gekennzeichnet, dass** die Isolationszusammensetzung zusätzlich ein Bindemittel umfasst.

5. Isolationszusammensetzung nach Anspruch 4, **dadurch gekennzeichnet, dass** das Bindemittel ausgewählt ist aus der Gruppe, bestehend aus Celluloseestern, Cellusoseethern, Kautschukderivaten, Polyesterharzen, ungesättigten Polyestern, Alkydharzen, Phenolharzen, Aminoharzen, Amidoharzen, Ketonharzen, Xylol-Formaldehydharzen, Epoxidharze, Phenoxyharzen, Polyolefinen, Polyvinylchlorid, Polyvinylestem, Polyvinylalkoholen, Polyvinylacetalen, Polyvinylethern, Polyacrylaten, Polymetacrylaten, Polystyrolen, Polycarbonaten, Polyestern, Copolyestern, Polyamiden, Silikonharzen, Polyurethanen und Mischungen davon, umfasst.

6. Isolationszusammensetzung nach Anspruch 4, **dadurch gekennzeichnet, dass** das Bindemittel ausgewählt ist aus der Gruppe der Polycarbonate.

7. Isolationszusammensetzung nach einem der Ansprüche 1 bis 6, **dadurch gekennzeichnet, dass** die Zusammensetzung ein Lösemittel ist ausgewählt aus der Gruppe, bestehend aus 2-Methoxy-1-methylethylacetat, 1,2,4-Trimethylbenzol, Ethyl-3-ethoxypropionat, Naphtha und Mischungen der zuvor erwähnten Lösemittel.

8. Isolationszusammensetzungen nach einem der Ansprüche 1 bis 7, **dadurch gekennzeichnet, dass** der Anteil an Abstandshalter, bezogen auf die Isolationszusammensetzung, 1 bis 90 Gew.-% beträgt.

9. Isolationszusammensetzung nach einem der Ansprüche 1 bis 8, **dadurch gekennzeichnet, dass** die Zusammensetzung mindestens einen weiteren Bestandteil, ausgewählt aus der Gruppe, bestehend aus Additiven, weiteren Füllstoffen und Mischungen davon, umfasst.

10. Isolationszusammensetzung nach einem der Ansprüche 1 bis 9 in der Form einer Isolationsschicht.

11. Verfahren zur Herstellung einer Isolationszusammensetzung gemäß einem der Ansprüche 1 bis 10, **dadurch gekennzeichnet, dass** man alle Bestandteile der Isolationszusammensetzung miteinander mischt.

12. Verwendung von Abstandshaltern wie in einem der Ansprüche 1 bis 10 definiert in Isolationszusammensetzungen.

13. Elektrischer Schaltkreis, umfassend mindestens ein Substrat sowie mindestens eine Isolationsschicht gemäß Anspruch 10.

14. Verwendung einer Isolationszusammensetzung gemäß einem der Ansprüche 1 bis 10 zum Zweck der Isolierung von übereinander angeordneten Leiterbahnen eines gedruckten Schaltkreises, insbesondere im Bereich gedruckter Elektronik, im HF-Design von koplanaren Antennenstrukturen und bei der Herstellung von RFID-Antennen und Displays.

**Figur 1**

**Figur 2**

Europäisches
Patentamt

European
Patent Office

Office européen
des brevets

## EUROPÄISCHER RECHERCHENBERICHT

**Nummer der Anmeldung**

EP 10 16 7011

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2002/058137 A1 (BERGSTEDT LEIF ROLAND [SE]) 16. Mai 2002 (2002-05-16) * das ganze Dokument * ----- | 1-14 | INV. H05K3/46 |
| X | DE 10 2004 058335 A1 (SCHULZ-HARDER JUERGEN [DE] ELECTROVAC AG [AT]) 14. Juni 2006 (2006-06-14) * Absatz [0002] - Absatz [0004] * * Absatz [0019] - Absatz [0020] * * Absatz [0033] - Absatz [0035]; Abbildung 3 * ----- | 1-14 | |
| X | US 2003/201155 A1 (KATAKAMI SEIKI [JP]) 30. Oktober 2003 (2003-10-30) * das ganze Dokument * ----- | 1-3,9-14 | |
| X | JP 7 037466 A (GUNZE KK) 7. Februar 1995 (1995-02-07) * Zusammenfassung * ----- | 1-3,10, 12-14 | |
| A | EP 2 182 019 A1 (SHOWA DENKO KK [JP]) 5. Mai 2010 (2010-05-05) * Zusammenfassung * * Absatz [0009] * * Absatz [0014] * * Absatz [0036] * ----- | 5-7 | **RECHERCHIERTE SACHGEBIETE (IPC)** H05K |

Der vorliegende Recherchenbericht wurde für alle Patentansprüche erstellt

| Recherchenort | Abschlußdatum der Recherche | Prüfer |
|---|---|---|
| Den Haag | 1. Oktober 2010 | Annibal, Stewart |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

 

& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 10 16 7011

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

01-10-2010

| Im Recherchenbericht angeführtes Patentdokument | Datum der Veröffentlichung | Mitglied(er) der Patentfamilie | | Datum der Veröffentlichung |
|---|---|---|---|---|
| US 2002058137 A1 | 16-05-2002 | AU | 1117102 A | 21-05-2002 |
| | | SE | 0004125 A | 11-05-2002 |
| | | WO | 0239797 A1 | 16-05-2002 |
| DE 102004058335 A1 | 14-06-2006 | WO | 2006056149 A1 | 01-06-2006 |
| | | EP | 1817945 A1 | 15-08-2007 |
| | | JP | 2008522387 T | 26-06-2008 |
| | | US | 2008118706 A1 | 22-05-2008 |
| US 2003201155 A1 | 30-10-2003 | JP | 3960850 B2 | 15-08-2007 |
| | | JP | 2003316517 A | 07-11-2003 |
| JP 7037466 A | 07-02-1995 | KEINE | | |
| EP 2182019 A1 | 05-05-2010 | CN | 101687980 A | 31-03-2010 |
| | | WO | 2009011304 A1 | 22-01-2009 |
| | | KR | 20100040932 A | 21-04-2010 |
| | | US | 2010186996 A1 | 29-07-2010 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- DE 4332282 A1
- DE 29824033 U1
- DE 102007028357 A1
- EP 1535957 A